# EUROPEAN PATENT SPECIFICATION

(11) **EP 3 775 432 B1**
(45) Date of publication and mention of the grant of the patent: **22.02.2023**
(21) Application number: 19715594.8
(22) Date of filing: 27.03.2019
(51) Int. Cl.: E04F 15/02, G05B 19/4097, E04F 15/08, E04F 15/10

(54) **SYSTEM AND METHOD FOR PRE-FABRICATION AND LAYING OUT OF COVERAGE OF A ROOM SURFACE**
SYSTEM UND VERFAHREN ZUR VORFERTIGUNG UND VERLEGUNG DER ABDECKUNG EINER RAUMFLÄCHE
SYSTÈME ET PROCÉDÉ DE PRÉFABRICATION ET DE POSE DE COUVERTURE D'UNE SURFACE DE PIÈCE

(30) Priority: 27.03.2018 SE 1850337
(43) Date of publication of application: 17.02.2021
(73) Proprietor: Stibe Modul AB, 289 90 Knislinge (SE)
(72) Inventor: ALFONSSON, Håkan, 289 90 Knislinge (SE)
(74) Representative: Zacco Sweden AB
(86) International application number: PCT/SE2019/050277
(87) International publication number: WO 2019/190386

(56) References cited:
- WO-A1-2018/009985
- GB-A- 2 437 370
- US-A1- 2015 315 773

## Description

### TECHNICAL FIELD

The invention relates to a system and method for pre-fabrication of plates/boards/tiles and laying out of them for covering at least a part of a surface of a room, which surface is at least a part of the inner floor, the inner wall and/or the inner roof or ceiling of the room.

### BACKGROUND ART

There are a lot of known ways of covering at least parts of an inner floor, one or more inner walls and/or inner roofs of a room with a desired surface coverage. The room could be a so called wet room, such as a bathroom or the like, or any other room in a house/residence.

One common known way of laying out coverage on a surface, e.g. a room floor, is to adapt the underlay "in-situ", such as the floor in a bathroom by first cleaning the floor and then apply different materials, often flowable putty that is poured out onto the floor. Then, a case putty is performed by use of a screed to form the floor putty into correct shape and desired sloping manually to fulfil current building regulations, and adapting the solidifying putty in relation to any present water in- and outlets, drainage, shower baths in the room and adjusting levels of the floor in regard of adjacent spaces or rooms. Levelling of floors before putting on putty is often done using laser equipment and/or spirit levels and appropriate distribution of levelling sticks manually over the floor, the sticks are cut into correct levels or heights. The putty is often mixed with water in buckets and poured out on the floor surface and smoothed/shaped manually with the screed. This way of working is done in principle in the same way independently of putting the putty onto a concrete floor or a wooden one. The difference is putty thickness and use of armouring/reinforcing by means of fibreglass mesh or metal mesh for wooden floors. These known ways of working is done for example in Sweden according to the national regulations for buildings, e.g. according to "Boverkets byggregler, BBR" and Terms of Business from GVK (foundation comprising the entities "Fastighetsägarna Sverige", "HSB Riksförbund", "Riksbyggen", "Sveriges Allmännyttiga Bostadsföretag SABO", "Svensk Försäkring", "Sveriges BostadsrättsCentrum SBC", "VVS Företagen" and "Golvbranschen GBR".

Different coverage materials are used, e.g. plastic mats laid onto the floor by gluing onto the putty, plates or boards of wood and/or wood chips/flakes/particles are laid directly on the putty or on scantling laid on the putty or clinker or ceramic/stone tiles are laid onto tile adhesive put on the putty. Known ways of providing coverage on a surface are disclosed in GB 2 437 370 A, US 2015/315773 A1, and WO 2018/009985 A1.

Known methods incur a high physical stress/strain on the operator/-s performing the work manually. This prior art way of working requires long experience and much training to be performed correctly and satisfactorily meaning that even experienced and talented operators are not able to make two identical or at least similar floors exactly the same as the work is done using feeling and experience. The final result is also only possible to check after the work is done and the putty has solidified. It means that delivering the same result/quality each time is difficult as the final result depends on the skills and handicraft of the operators and any corrections of wrongly sloping surfaces are very difficult to perform without having to hewn the floor and redo the puttying and layout of surface coverage again. The work environment is tough and a heavy burden for the workers as several tons of putty mixed with water are carried daily wearing out the operators meaning that many of them are not able to work until they reach retirement, at least not full time. Many operators also get occupational injuries that make them unable to work from time to time.

### SUMMARY OF THE INVENTION

One object of the present invention is to provide a system and method for coverage of at least a part of an inner surface of a room, preferably a wet room, such as a bathroom or the like, by means of a plurality of pre-fabricated and laid out plates or boards or tiles that solve or at least reduce or diminish the above problems.

An object of the present invention is to provide a system and method for coverage of at least a part of an inner surface of a wet room, such as a bathroom or the like, by means of a plurality of pre-fabricated and then laid out plates or boards or tiles of which at least one plate or board or tile is preformed by being processed on the underside to be adapted to and to fit against an upper surface of the inner room surface to level out any unevenness of the upper inner room surface that it thereafter covers after layout and at least one other plate or board or tile of this plurality of pre-fabricated and then laid out plates or boards or tiles is also preformed by being processed on both its underside and its upper side to be adapted to and to fit against an upper surface of the inner room surface to level out any unevenness of the upper inner room surface that it thereafter covers after layout and simultaneously to achieve an inclination/slope/rake at/on its upper side after layout to create an inclination/slope/rake of the upper inner room surface that it covers/forms after layout to fulfil standards of wet room drainage or outflow of water, at least in Sweden but also according to other national regulations for making wet rooms. The present invention enables laying out of preformed plates or boards or tiles that form a 3D puzzle both horizontally and vertically fulfilling levelling out unevenness of inner wet room surfaces while creating correct inclination/slope/rake of the upper inner wet room surface after layout to a finished wet room surface to secure allowed/sufficient wet room drainage/water outflow.

An object of the present invention is to provide a system and method for coverage of at least a part of an inner surface of a wet room, such as a bathroom or the like, by means of a plurality of pre-fabricated and then laid out plates or boards or tiles of which at least one plate/board or tile is preformed by being processed on all sides except its upper side to be adapted to and to fit against an upper surface of the inner room surface to level out any unevenness of the upper inner room surface that it thereafter covers after layout and be fitted to adjacent other laid out plates or boards or tiles and at least one other plate or board/tile of this plurality of pre-fabricated and then laid out plates/boards or tiles is also preformed by being processed on all its sides, including its underside and its upper side, to be adapted to and to fit against an upper surface of the inner room surface to level out any unevenness of the upper inner room surface that it thereafter covers with its underside after layout and be fitted to adjacent other laid out plates or boards/tiles and simultaneously to achieve an inclination/slope/rake at/on its upper side after layout to create an inclination/slope/rake of the upper inner room surface that it covers/forms after layout to fulfil standards of wet room drainage or outflow of water, at least in Sweden but also according to other national regulations for making wet rooms.

Yet an object of the present invention is to enable laying out of preformed plates or boards or tiles in a 3D puzzle both horizontally to fit against other such preformed plates or boards or tiles or walls or the like of the inner wet room and vertically to level out unevenness in the upper surface of the inner wet room and at the same time, if required at that area and/or the full area of the wet room, to achieve/create/secure an inclination/slope/rake of the wet room surface that it covers/forms after layout to fulfil standards of wet room drainage and water outflow, at least in Sweden but also according to other national regulations for making wet rooms.

Another object of the present invention is to provide a system and method for coverage of at least a part of an inner surface of a wet room by means of a plurality of pre-fabricated and laid out plates or boards or tiles that accomplish easier handling and working by reducing the heavy burden on the operator and cumbersome working posture of the operator before, during and after performing the coverage of the room surface.

Yet another object of the present invention is to provide a system and method for coverage of at least a part of an inner surface of a wet room by means of a plurality of pre-fabricated and laid out plates or boards or tiles that enables a more efficient and quicker way of working before, during and after coverage of the room surface accordingly.

Still another object of the present invention is to provide a system and method for coverage of at least a part of an inner surface of a wet room by means of a plurality of pre-fabricated and laid out plates or boards or tiles that provides a better reproducibility in regard of quality of work and final result for each room surface coverage before, during and after the work and in a more simplified way reducing the need of experience and training for the work and also facilitates the control of the final result.

One more object of the present invention is to provide a system and method for coverage of at least a part of an inner surface of a wet room by means of a plurality of pre-fabricated and laid out plates or boards or tiles that enables more predictable planning and possibility of such work further away and at different sites with even unexperienced workers or workers that do not need as much experience and training as for prior art methods and provides more precise timing as the pre-fabrication gives a better overview and also less waste or loss of material, in particular excess and solidified putty that has to be handled after the work is done and also has solidified too quickly before the work was done or even started.

These objects are achieved by a system and method for coverage of at least a part of an inner surface of a wet room by means of a plurality of pre-fabricated and laid out plates, boards or tiles according to the related independent claims with preferred embodiments defined in associated dependent claims.

According to the invention, a system is provided for coverage of at least a part of an inner surface of a wet room by means of a plurality of pre-fabricated and laid out plates, the system comprising laid out points of reference on the inner room surface, a 3D scanner adapted to scan the part of the inner room surface and the points of reference into a plurality of points of measuring (a cloud of measure points) to enable creating a digital 3D representation of the part of the inner room surface, a CAD/CAM system configured to receive the points of measuring from the 3D scanner and to create the digital 3D representation of the part of the inner room surface based on the points of measuring and to transform the digital 3D representation into a suitable number of individual digital plates with identification and dimensions and a CAM controlling manufacturing workflow to manufacture each individual plate accordingly, at least one CAD/CAM controlled machine configured to receive the CAM controlling manufacturing workflow and to physically manufacture the plates individually accordingly, and a layout of each individually pre-fabricated plate in the room according to the predefined digital 3D representation, wherein the CAM controlling manufacturing work-flow is adapted to control the at least one CAD/CAM controlled machine when manufacturing each plate individually at least on its underside and its upper side to preform the plate to fit the upper surface of the inner room surface onto which it is to be laid with its underside and to fit its upper side into (to accomplish) any predefined (desired/final) slope of the final inner room surface when finished to enable drainage or outflow of water or the like.

Further objects and features of the present invention will appear from the following definitions of aspects/embodiments of the invention.

According to an aspect of the invention, in the system according to the above or any of the below, the at least one CAD/CAM controlled machine is configured to physically manufacture and mark the plates individually accordingly, and the transformation of the digital 3D representation of the inner room surface by means of the CAD/CAM system comprises dividing the digital 3D representation of the inner room surface into a digital grid pattern with a suitable number of individual digital pieces corresponding to the individual plates making up the inner room surface and identifying and dimensioning each individual plate digitally to enable pre-fabricating each individual plate physically by means of the CAM controlling manufacturing workflow before laying-out the individual plates after manufacture according to the predefined grid pattern in the room.

According to another aspect of the invention, in the system according to any of the above or below, the CAM controlling manufacturing workflow is adapted to control the at least one CAD/CAM controlled machine for manufacturing each plate individually on at least one side.

According to yet an aspect of the invention, in the system according to any of the above or below, the CAM controlling manufacturing workflow is adapted to control the at least one CAD/CAM controlled machine when manufacturing each plate individually on at least either an underside or an upper side to preform the plate to fit the upper/top inner surface of the room when it is laid thereon with its underside.

According to still an aspect of the invention, in the system according to any of the above or below, the CAM controlling manufacturing workflow is adapted to control the at least one CAD/CAM controlled machine when manufacturing each plate individually on an underside and an upper side to preform the plate to fit the upper surface of the room onto which it is to be laid with its underside and to fit/adapt its upper side into any final predefined slope of a finished inner room surface to enable drainage or outflow of water or the like.

According to one aspect of the invention, in the system according to any of the above or below, the CAM controlling manufacturing workflow is adapted to control the at least one CAD/CAM controlled machine when manufacturing each plate individually to accomplish any predefined slopes of the finished inner room surface and making any opening through one or more associated plates as lead-through for any drain and/or water inlet or gully drain in the room if required according to the digital 3D representation of the inner room surface.

According to yet another aspect of the invention, the system according to any of the above or below comprises at least one packing adapted to pack the pre-fabricated plates in a pre-defined order according to the individual marking of each plate into at least one package of plates before the layout of each individual plate of the package in the room according to the predefined digital 3D representation.

According to another aspect of the invention, the system according to any of the above or below comprises at least a transport to deliver at least one plate package or the at least one plate package at the room before the layout of each individual plate in the room according to the predefined digital 3D representation.

According to the invention, a method of pre-fabricating and laying out plates for coverage of at least a part of an inner surface of a wet room is provided, the method comprising laying out points of reference on the inner room surface, 3D scanning of the part of the inner room surface and the points of reference into a plurality of points of measuring (a cloud of measure points), sending the plurality of points of measuring from the 3D scanning to a CAD/CAM system, creating a digital 3D representation of the inner room surface based on the received points of measuring from the 3D scanning by means of the CAD/CAM system, transforming the digital 3D representation into a suitable number of individual digital plates with identification and dimensions and a digital CAM controlling manufacturing workflow for physically manufacturing each individual plate accordingly for pre-fabrication, sending the digital CAM controlling manufacturing workflow to at least one CAD/CAM controlled machine for manufacturing the physical plates individually accordingly, and laying out each individually pre-fabricated plate in the room according to the predefined digital 3D representation, characterized by the CAM controlling manufacturing workflow comprising manufacturing each plate individually at least on its underside and its upper side to preform the plate to fit the upper surface of the inner room surface onto which it is to be laid with its underside and to fit its upper side into any predefined (desired/final) slope of the final inner room surface when finished to enable drainage or outflow of water.

Further objects and features of the present invention will appear from the following definitions of aspects/examples/embodiments of the invention.

According to an aspect of the invention, the method according to the above and any of the below, wherein the at least one CAD/CAM controlled machine for manufacturing marks the physical plates individually accordingly, and transforming the digital 3D representation of the inner room surface comprises dividing the digital 3D representation into a digital grid pattern with a suitable number of individual digital pieces corresponding to the physical individual plates making up the inner room surface and identifying and dimensioning each individual piece digitally to enable pre-fabricating each individual plate physically by means of the CAM controlling manufacturing workflow before laying out the individual plates physically after manufacture according to the predefined grid pattern in the room.

According to another aspect of the invention, the method according to any of the above and below, wherein the CAM controlling manufacturing workflow comprises manufacturing each plate individually on at least one side.

According to yet an aspect of the invention, the method according to any of the above and below, wherein the CAD/CAM controlled manufacturing workflow comprises manufacturing each plate individually on at least either an underside or an upper side preforming the plate to fit the upper/top inner surface of the room when laid thereon with its underside.

According to still an aspect of the invention, the method according to any of the above and below, wherein the CAM controlling manufacturing workflow comprises manufacturing each plate individually on an underside and an upper side to preform the plate to fit the upper room surface onto which it is to be laid with its underside and to fit/adapt its upper side into any final predefined slope of the finished inner wet room surface to enable drainage or outflow of water.

According to one more aspect of the invention, the method according to any of the above and below, wherein the CAM controlling manufacturing workflow forms each plate individually to accomplish any predefined slopes of the finished inner room surface and makes any opening through one or more associated plates to preform lead-through for any drain and/or water inlet or gully drain in the room if required according to the digital 3D representation of the inner room surface when covering the inner room surface.

According to yet another aspect of the invention, the method according to any of the above and below comprises packing of the pre-fabricated plates in a pre-defined order according to the individual marking of each plate into at least one package of plates before laying out each individual plate in the room according to the predefined digital 3D representation.

According to an aspect of the invention, the method according to any of the above and below comprises transport for delivery of at least one plate package at the room before the layout of each individual plate in the room according to the predefined digital 3D representation.

### BRIEF DESCRIPTION OF THE DRAWINGS

The invention will now be explained in further details with reference to the drawings showing aspects/embodiments thereof.
Figure 1 shows steps performed for coverage of at least a part of an inner surface of a room by means of a plurality of pre-fabricated and laid out plates, boards or tiles in a system and by a method according to the invention.
Figure 2 shows steps performed for coverage of at least a part of an inner surface of a room by means of a plurality of pre-fabricated and laid out plates, boards or tiles in a system and by a method according to the invention.
Figure 3 shows a step for initiating coverage of at least a part of an inner surface of a room by means of a plurality of pre-fabricated and laid out plates, boards or tiles according to Fig. 1.
Figure 4 shows a step performed after the step of Fig. 3 and according to Fig. 1.
Figure 5 shows a step performed after the step of Fig. 3 but performed simultaneously with or after the step of Fig. 4 and according to Figs. 1 and 2.
Figure 6 shows a step performed after the steps of Figs. 3 and 4 but performed simultaneously with or after the step of Fig. 5 and according to Fig. 2.
Figure 7 shows a final step performed after the step of Fig. 6 and according to Figs. 1 and 2.
Figures 8A and 8B show a step performed after the step of Fig. 3 and/or according to the step of Fig. 4 and/or after or during the final step of Fig. 7 and according to Figs. 1 and 2.
Figure 9 shows a final step performed after the final step of Fig. 7 and Figs. 1 and 2.

### DETAILED DESCRIPTION

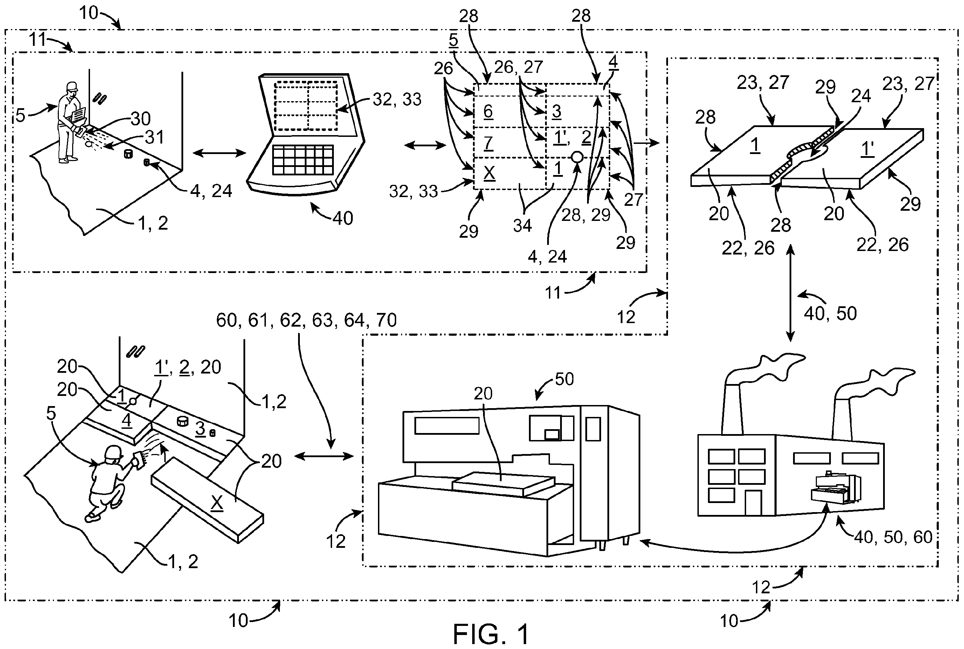

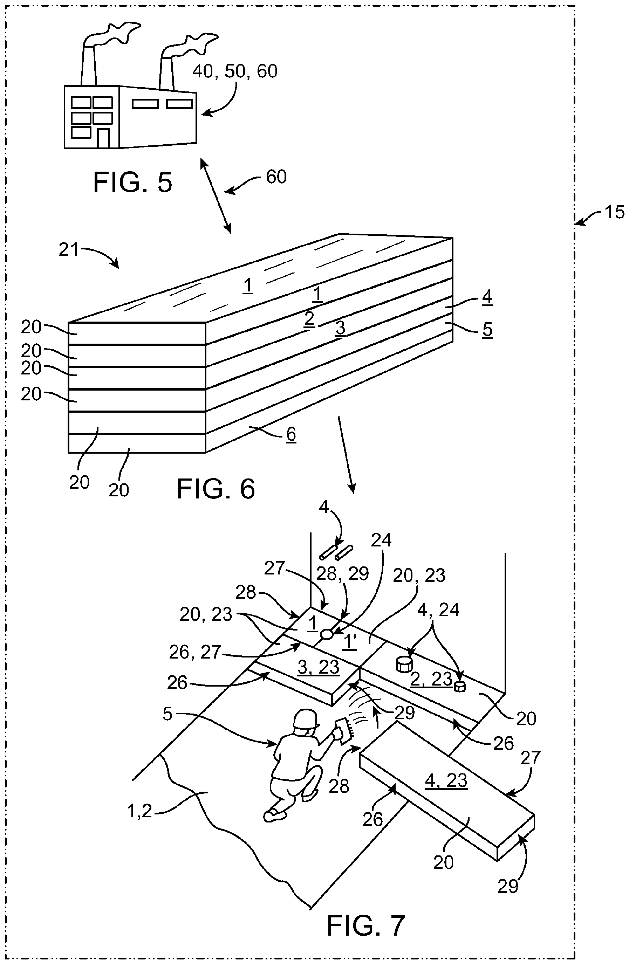

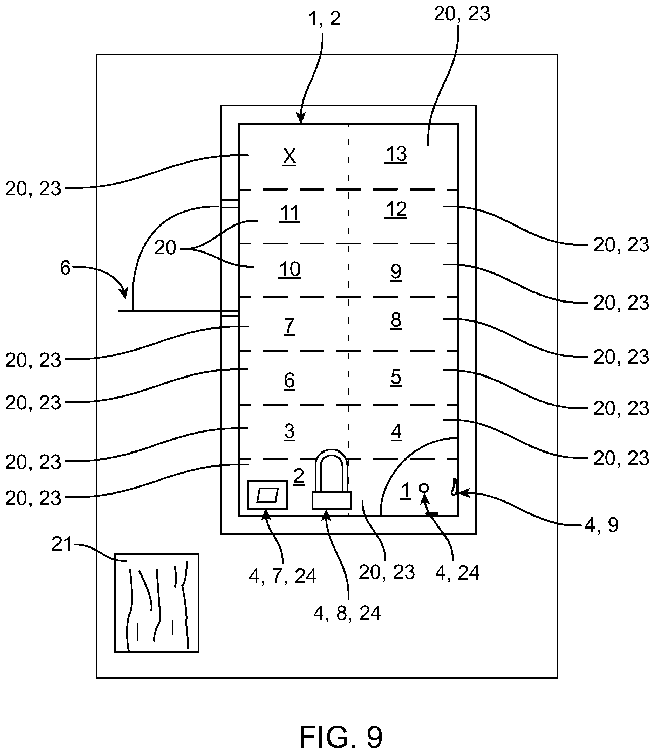

Aspects/Embodiments of the invention are disclosed below by reference to figures 1 to 9.

The invention concerns a system 10 and method for coverage of at least a part of an inner surface 2 of a room 1, preferably a wet room, such as a bathroom, laundry/utility room or the like, by means of a plurality of pre-fabricated and laid out plates, boards or tiles 20. Such a plate, board or tile 20 comprises an underside 22, an upper side 23, a first end or side 26, a second end or side 27, a third end or side 28 and a fourth end or side 29, see figs. 1, 2, 7, 8A and 8B. These plate ends or sides 26, 27, 28 and 29 could be arranged pairwise opposite each other as the underside 22 and upper side 23 depending on the shape/preforming of the plate 20. These plate ends or sides 26, 27, 28 and 29 could be arranged pairwise at an angle between each other, such as 90° (perpendicular to each other) or at any angle less or larger than that depending on the final preformed desired shape of the plate 20. These plate ends or sides 26, 27, 28 and 29 could be pairwise arranged and extending in planes being in parallel with each other or angled in relation to each other depending on the final preformed shape of the plate 20. The underside 22 is adapted to be laid against the upper surface of the wet room 1. The upper side 23 is adapted to form a top layer of the wet room 1 when finished. The top layer/upper side 23 after being finished is plane, partly plane and/or partly sloping or sloping over its whole surface. The top layer/upper side 23 after being finished at least partly sloping or with a slope over its whole surface could have one sloping/rake at/on one part of its surface and another sloping/rake at/on another part of its surface. These varying slopes/rakes could be inclined in the same or similar directions or even opposite directions depending on the demands to fulfil regarding wet room standards/regulations. The same goes for plates 20 and their upper sides 23 laid out adjacent to each other. Each of the plate or board or tile ends or sides 26, 27, 28, 29 is adapted to be laid against or adjacent ends 26, 27, 28, 29 of other plates, boards or tiles 20 or a wall or the like in the wet room 1. This laying out of which ends or sides 26-29 against which other ends depends on the shape of the finished plate 20, i.e. end 26 on one plate could be arranged against any other end 27-29 of other plates and vice versa. Demands regarding wet rooms 1 concerning floor-laying are to fulfil standards of drainage and/or outflow of water correctly by guiding the outflow according to standards such as level of slopes and their directions. The system 10 and method of the present invention enables laying out the preformed plates 20 that form a 3D puzzle that both horizontally and vertically level out unevenness of inner wet room surfaces 2 where required while creating correct inclination/slope/rake of the upper inner wet room surface where required when finished to secure allowed/sufficient wet room drainage/water outflow. The inventive system 10 and method not only enables making uneven floors even/plan/flat but also enables making the floor of a room into an approved wet room by evening out the inner room surface after laying out the plates 20 while at the same time establishing a correct sloping on the finished floor for water drainage and outflow, both partly and/or over the whole inner room surface 2 made up of the upper side 23 of each plate 20. The system 10 comprises points of reference 3 to be laid out or which are laid out on the inner wet room surface 2. As no inner room 1 and/or inner surface 2 of such a wet room is exactly alike any other inner room 1 or its inner room surface 2, each inner room and its inner room surface is unique in regard of measures/dimensions, slopes/inclinations/gradients, flatness, warping, levels, positions or placements of gullies and/or sinks, drains/drainage, flowing/sewer 4, or holes/openings 24 as parts of the floor and/or walls and/or ceiling of the room 1, and the actual inner room 1 and inner room surface 2 are scanned each time by a 3D scanner 30. This scanner and scanning 30 is adapted to scan the inner room surface 2 being at least part of the floor, walls and/or ceiling of the room 1 and the reference points 3 into a plurality of points of measuring 31. Scan 30 is done to create a digital 3D map representation 32, 33, 34, 35 of the inner room surface part 2 to be covered including its measures/dimensions, slopes, levels, inclinations/gradients, flatness, warping, positions or placements of at least one gully or sink, drain or drainage, flowing or sewer, water inlets and/or outlets 4 or the like being common entities in rooms, at least in a bathroom 1. The inner surface 2 could be part of a stair case and/or stairs to be covered with such pre-fabricated plates, boards and/or tiles 20. The inner surface 2 could be other parts, such as thresholds, i.e. doorsteps; or skirting boards for floors, walls and/or ceilings; or one or more steps of a stair case or part of one or more steps or the whole stair case and/or stairs themselves, to be laid out as coverage, in some aspects, in combination with the pre-fabricated plates, boards and/or tiles 20. The invention is combinable with use of a small, portable CNC machine for manufacturing or specially manufacture building parts on site, e.g. to cut out and/or sealingly fit thereby specially made surface coverage, i.e. at least parts of tiles, boards made of wood, stone and/or textile where required.

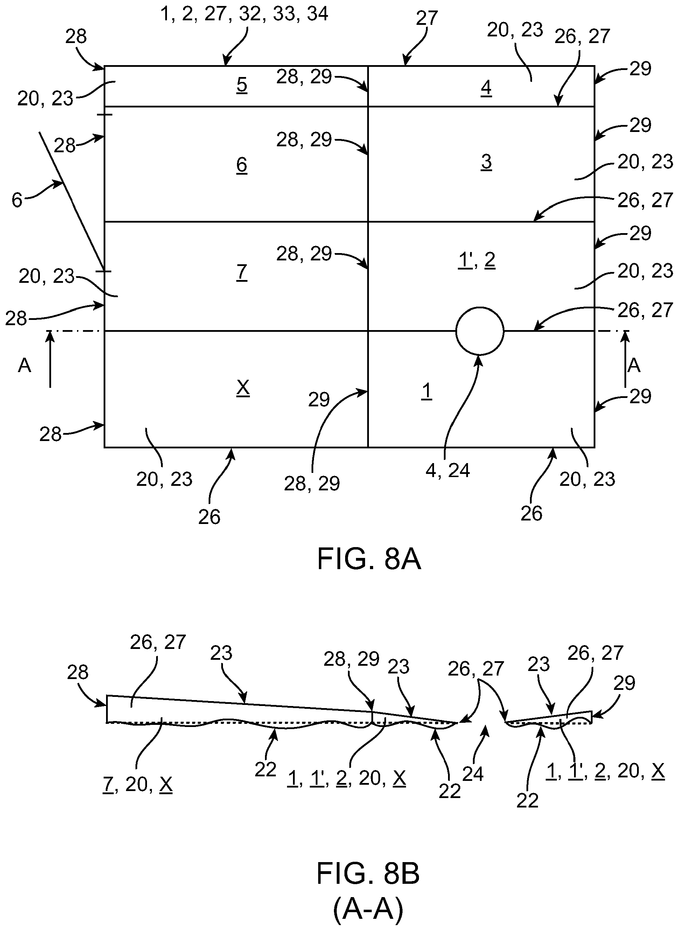

In fig. 8B, the underside 22 is shown adapted (by processing) to the underlay or upper surface of the inner wet room surface 1, 1', 2 in solid lines and if it is not adapted in any way, its contour is shown with dotted lines. In most scenarios, each plate 20 must be adapted both on its underside 22 (into a schematically shown shape or profile in solid lines of fig. 8B) and on its upper side 23 to fulfil the sloping criteria for at least a part and/or the whole room surface 2 in regard of wet room standards/approval.

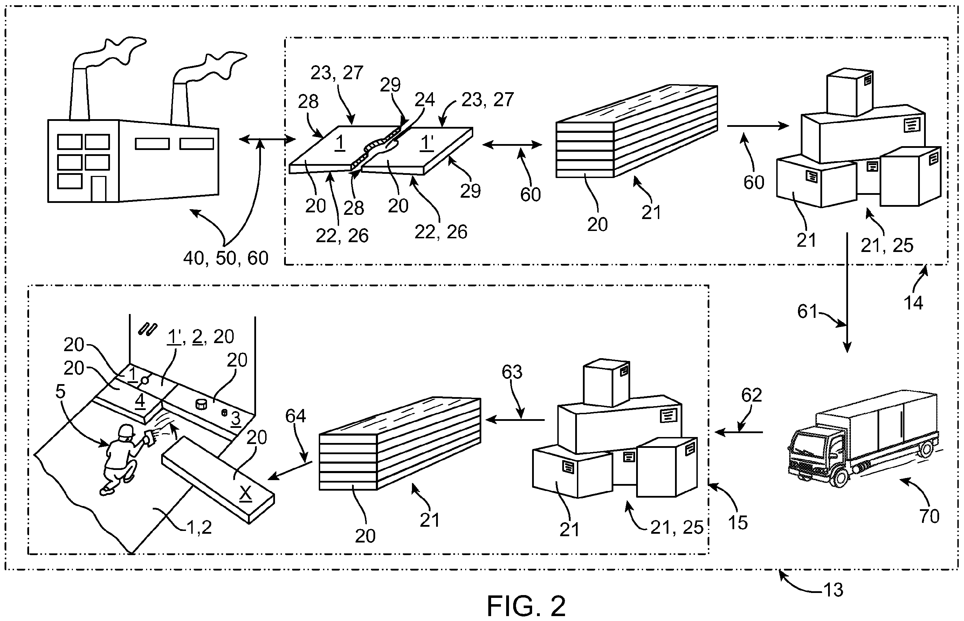

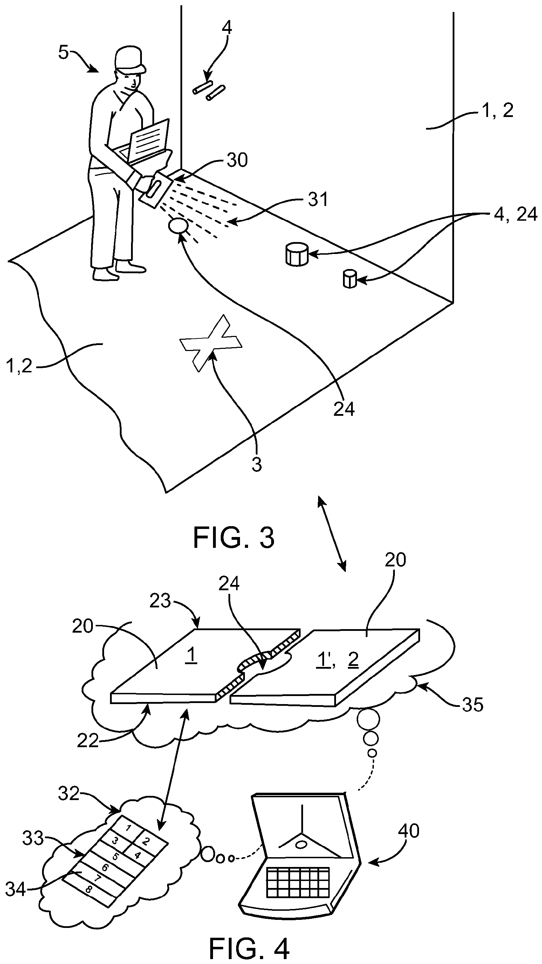

The inventor has invented a system 10, 11, 12, 13, 14 and a method to adapt and pre-fabricate coverage material into "tailor-made" underlay material of relevant plate material 20 being divided into, for the inner surface part 2, relevant geometrical parts that subsequently, during installation in the room 1, are distributed in a predefined order over the inner surface. Each plate 20 is prefabricated by forming/shaping at least its underside 22 and/or upper side 23 or both these sides or more of its sides to adapt the shape and dimension of each individual plate to the specific inner surface 2 and the 3D space required in the wet room 1. In some areas of a wet room 1 where only levelling out of unevenness in its upper surface is required one or more plates 20 is prefabricated by forming/shaping at least its underside 22 and one or more of its ends or sides 26, 27, 28 and/or 29. In other areas of the wet room, one or more plates 20 is prefabricated by forming/shaping at least its underside 22 and its upper side 23. In yet other areas of the wet room 1, one or more plates 20 is prefabricated by forming/shaping at least its underside 22 and its upper side 23 and/or one or more of its ends or sides 26, 27, 28 and/or 29. In some aspects, a minority or majority/most of the plurality of the plates 20 making up the wet room 1 is prefabricated by forming/shaping at least their undersides 22 and their upper sides 23 and/or one or more of their ends/sides 26, 27, 28, 29. All plates 20 making up the wet room 1 is prefabricated by forming/shaping at least their undersides 22 and/or their upper sides 23 and/or one or more of their ends/sides 26, 27, 28, 29. The inventive pre-fabrication process is divided into several partial processes. A first process concerns scanning 30 the inner surface 2 for the creation of a CAD drawing being unique for the inner surface 2 and room 1, which is used to control the pre-manufacturing of the plates 20, see the three left upper views in Fig. 1 visualized in box 11 and Figs. 3 and 4. A second process concerns applying the CAD drawing into a relevant CAM processing scheme to be used by appropriate manufacturing equipment 40 to control and perform manufacturing of each actual plate 20, see the top right view and the two lower right views of Fig. 1 visualized in box 12, and the two upper left views in Fig. 2. A third process 11 concerns marking each pre-fabricated and finished plate 20 and packing them in a correct order in one or more packages 21 and/or set of packages 25, see the three upper right views visualized in box 14 and/or all the four upper views in Fig. 2 (in this process a unique installation instruction is also compiled and enclosed in the package 21). A fourth process 12 concerns unpacking each pre-fabricated and finished plate 20 in correct order from the packages 21, see the three lower left views of Fig. 2 and Figs. 5, 6, and 7 visualized in box 15 (in this process the unique installation instruction is used to correctly install the plates 20 in the room 1 and on the inner surface 2 in the correct pre-defined pattern). The processes of boxes 14 and 15 in combination with the transport 70 are visualized in a box 13 of Fig. 2.

The scanner 30 is a portable 3D scanner that could be handheld by an operator 5 or user or installer of pre-fabricated plates 20 during scanning. The scanner 30 is laser equipment and/or one or more cameras configured for 3D scanning of surfaces/volumes The room 1 has a door 6 and if the room is a bathroom it usually comprises at least one washbasin 7, toilet 8 and/or shower or shower bath and/or bathtub 9. Before the inventive system 10 and method are applied to the room 1, which could be a residential room or apartment and/or an office or office space having no surface layer or underlay to such a surface layer, the room is prepared, e.g. by cleaning, for installation of surface coverage including material for foundation or bedding or underlay or subfloor. Alternatively, one or more digital cameras 30 is/are used for creating one or more 3D models of the surface 2 by photogrammetry, whereby one or more "clouds of measuring points" is/are created by means of at least two or a plurality of digital images, enabling to read/scan the surface 2 in a corresponding way as the 3D scanner. Alternatively, structured light 3D scanners or "white light" 3D scanners, most structured light 3D scanners using a blue or white LED projected light is usable. These 3D scanners project a light pattern consisting of bars, blocks or other shapes onto an object. The 3D scanner has one or more sensors that look at the edge of those patterns or structure shapes to determine the objects 3D shape of the surface 2. Using the same trigonometric triangulation method as laser scanners, i.e. the 3D scanner 30, the distance from the sensors to the light source is known whereby one or more "clouds of measuring points" is/are achievable accordingly as for the techniques above. Structured light scanners can be tripod mounted or hand held The inner surface 2 of the room 1 to be covered by the pre-fabricated material in form of plates or boards and/or tiles 20 are scanned by the portable scanning equipment 30. Before doing this the inner surface 2 to be covered has been provided with required reference points 3 and horizontal lines and/or vertical lines, e.g. a digital water/spirit level with known length can be used. To be able to pre-fabricate the plates 20 to cover the inner surface 2 as a final result a design of a digital manufacturing scheme or programme for pre-shaping/pre-manufacturing these plates is performed by usage of the scanned data in the scanner 30. This data is forwarded to a CAD/CAM system 40 after scanning, e.g. a suitably equipped PC. The adaptation to any drainage, water inlet/outlet 4 on the inner surface 2, any shower walls or compartment in the room 1 and any levelling in relation to adjacent space/-s could be put into the digital manufacturing scheme or programme manually together with choice of cover material, i.e. type of plates 20. In the digital manufacturing scheme or programme, the inner surface 2 being scanned into a 3D representation 32 is divided into a suitable number of digital pieces 34 of a digital grid pattern 33, similar to a digital puzzle, and into digital representations 35 of each of the plates 20 in 3D to be physically manufactured accordingly. The plates 20 are suitably identified, e.g. by individual number markings, both digitally and physically to be easy to install according to the predefined grid pattern 33 at the final site, i.e. the actual room 1. One possible pattern is to layout the first plate 20 or 1 or 1'to the furthest left as seen from a door 6 and then laying out subsequent plates 20 or 2 or 3 or X from/to the right of the first plate 20/1/1'.

Figure 1 shows the scanning by scanner 30 into data forwarded to the CAD/CAM system 40 receiving the points of measuring 31 from the 3D scanner 30. Figure 1 shows the CAD/CAM system 40 creating the digital 3D representation 32 of the part of the inner room surface 2 based on the points of measuring and transforming the digital 3D representation 32 into the grid pattern 33 with a suitable number of the individual digital plates 34 with unique identification and dimensions and a CAM controlling manufacturing workflow to manufacture each individual plate 20 accordingly. In Figure 1, at least one CAD/CAM controlled machine 50 is shown receiving the CAM controlling manufacturing workflow and physically manufacturing and marking the plates 20 individually as unique entities accordingly. Figure 1 also shows the lay- out and installation of each individually pre-fabricated plate 20 on the inner surface 2 in the room 1 according to the predefined digital 3D representation 32, 33, 34, 35. The inner surface 2 is a floor but could of course be part of the walls and/or ceilings or a combination.

The individual markings of the plates 20 with numerals being underlined, such as 1, 1', 2, 3, 4, 5, 6, 7, 8, 9, 10, 11, 12, 13, and X in Figs. 1, 2, 4, 6, 7, 8A, 8B, and 9 are used to denote each individual plate 20 so that each plate is individually formed/manufactured and packed correctly in a correct order before being transported to the room, and in a correct package 21, and laid out at its correct position in the room/space/part 1, 2 and plates that are intended to together make-up for example a sewer, i.e. an opening for it is denoted as a pair with numerals 1 and 1', and may be identical or have different dimensions and/or shapes.

The methods of pre-fabrication/pre-manufacturing of the plates 20 could be subtractive and/or additive manufacture, such as cutting, milling, turning, e.g. wood peeling, casting or moulding, e.g. of plastic or composite or stone or ceramic tiles, 3D printing, or lamination of plates in one or more steps or any method being a combination of one or more of the above.

Figure 1 shows the inventive system 10 and method in full while Figures 2, 5, 6, and 7 show the practical handling of the pre-fabricated plates 20 in more detail, i.e. concerning packaging 60 the plates 20 into one or more packages 21, loading 61 the packages 21 onto a transport 70, e.g. a truck/lorry or fork lift truck, unloading 62 one or more plate packages 21 from the transport 70 and moving 63 one or more of the plate packages 21 to the installation site, e.g. just outside the room 1, and finally unpacking 64 the plate packages 21 for final installation of individual plates 20 on the inner surface 2 of the room 1.

In addition to the above parameters of dimensions etc. of the plates, the designer could add additional information into the digital manufacturing scheme or programme, e.g. apartment or room number, address of delivery, any marking or identification of their own, such as order number, or the like. This additional information enables providing basis for invoicing, packing and transport. The pre-shaping and pre-dimensioning of the plates 20 depends on if the inner surface 2 is flat or not, i.e. if it comprises sloping or not, and also if other ends or sides 26-29 of the plates 20 are to be adapted besides their undersides 22 and/or upper sides 23, then up to six plate sides could be adapted, e.g. if the plate is parallelepipedic. If a flat floor, wall or ceiling is to be achieved partly, it may be sufficient to only machine the underside 22 or the upper side 23, not both sides of one or more plates 20 while the remaining area of the inner room surface requiring a sloping for the exposed part of the finished inner surface 2, most often both the underside 22 and the upper side 23 of remaining plates 20 to laid there have to be machined accordingly, however, no machining of the underside 22 is required if the underlay onto which the plate 20 is laid with its underside 22 is totally flat. Most often in wet rooms 1, both the underside 22 and the upper side 23 of at least one or more plates must be adapted/processed/machined before laying them out. Frequently, edges 26-29 of the plates 20 will be manufactured so that the plate comprises some type of tongue and groove jointing. Cellular or expanded plastic could be moulded or machined to smooth the underlay onto which the plates 20 are to be laid and then laying the plates as an additional layer, such as fiberboards 20 with a surface layer. The weight of the laid layer is then reduced and the pressure or load on for example an older or existing joist frame or wood joist ceiling is thereby educed. This construction may be laid as a floating floor without gluing if the floor is to be covered with parquet, laminate or other board materials. If 3D printing is used to pre-manufacture the plates 20, there arises no need for additional machining or the like as the plates then are manufactured exactly according to the CAD/CAM scheme. The invention enables pre-fabricating underlay, sealing or waterproof compound and surface coverage (for a wet room, i.e. a bathroom 1) in one and the same plate or module 20 meaning that the installation is made more effective and a uniform quality is able to be maintained/achieved. In that case, any joints between the plates or modules 20 are sealed/spliced. In such modules 20, integration of underfloor heating is possible. The invention enables performing so many steps as possible in one operation or process to eliminate as many manual steps as possible and at the same time increase the quality of the work and final resulting surface coverage.

Additionally, the digital manufacturing scheme or programme is able to design the final finished sloping of the inner surface 2, e.g. to accomplish laying large clinker or ceramic tiles being as large as 60 x 60 cm without too large differences in levels between plates 20. Hence, also an installation instruction for the installer is able to be compiled. As an additional advantage, each plate 20 could be formed at least partly non-solid, e.g. by machining the underside 22 so that the plate weighs less or underfloor heating is able to be fitted to it. Hence, no additional adaptation of any plate 20 is required "in-situ".

The system 10 and method according to the invention are used for coverage of at least a part of the inner room surface 2 by means of a plurality of pre-fabricated and laid out plates 20. The system 10 and method comprises laid out/laying out of the points of reference 3 on the inner room surface 2, and scanning by means of the 3D scanner 30 the part of the inner room surface 2 and the points of reference 3 into the plurality of points of measuring 31 enabling creating the digital 3D representation 32, 33, 34, 35 of the inner room surface 2. The inventive system 10 and method uses the CAD/CAM system 40 configured to receive the points of measuring 31 from the 3D scanner 30 and to create the digital 3D representation 32, 33, 34, 35 of the inner room surface part 2 based on the measuring points and to transform the digital 3D representation into the suitable number of individual digital plates 34 with identification and dimensions and the CAM controlling manufacturing workflow to manufacture each individual plate 20 accordingly. The inventive system 10 and method use the at least one CAD/CAM controlled machine 50 configured to receive the CAM controlling manufacturing workflow and physically manufacture and mark the plates 20 individually accordingly. Then the layout of each individually pre-fabricated plate 20 in the room 1 is performed according to the predefined digital 3D representation 32, 33, 34, 35.

In an aspect of the inventive system 10, the transformation of the digital 3D representation 32 of the inner room surface 2 by means of the CAD/CAM system 40 comprises dividing the digital 3D representation of the inner room surface into the digital grid pattern 33 with the suitable number of individual digital pieces 34, 35 corresponding to the individual plates 20 making up the inner room surface and identifying and dimensioning each individual plate digitally to enable the pre-fabrication of each individual plate physically by means of the CAM controlling manufacturing workflow before laying-out the individual plates after manufacture according to the predefined grid pattern in the room 1. In another aspect of this system 10, the CAM controlling manufacturing workflow is adapted to control the at least one CAD/CAM controlled machine 50 for manufacturing each plate 20 individually on at least one side 22, 23. In one more aspect, the CAM controlling manufacturing workflow is adapted to control the at least one CAD/CAM controlled machine 50 when manufacturing each plate 20 individually on at least either the underside 22 and/or upper side 23 to preform the plate to fit the exposed or upper/top or lower inner wet room surface 2 when it is laid thereon with its underside.

In one aspect of the system 10, the CAM controlling manufacturing work-flow controls the at least one CAD/CAM controlled machine 50 to manufacture each plate 20 individually on an underside 22 and an upper side 23 to preform the plate to fit the exposed or upper or lower room surface 2 onto which it is to be laid with its underside 22 and to fit its upper side 23 into any predefined slope of the finished inner room surface to enable drainage 4 or outflow of water or the like or for compensating for bulging walls or ceilings of room 1. In another aspect of the system 10, the CAM controlling manufacturing workflow is adapted to control the at least one CAD/CAM controlled machine 50 when manufacturing each plate 20 individually to accomplish any predefined slopes of the finished inner room surface 2 and making any opening 4, 24 through one or more associated plates as lead-through for any drain and/or water inlet or gully drain in room 1 if required according to the digital 3D representation of the inner room surface. An additional aspect of the system 10 comprises at least one process of packing 60 adapted to pack the pre-fabricated plates 20 in a pre-defined order according to the individual marking of each plate into at least one package 21 or two or more packages into a set 25 of plate packages before layout of each individual plate of each package 21 in the room 1 according to the pre-defined digital 3D representation 32, 33, 34. System 10 in another aspect comprises at least the transport 70 to deliver the at least one plate package 21 at room 1 before layout of each individual plate in the room according to the predefined digital 3D representation 32, 33, 34.

The method according to the invention concerns pre-fabricating and laying out plates 20 for coverage of at least a part of the inner room surface 2 and comprises laying out the points of reference 3 on the inner room surface 2 and performing the 3D scanning 30 of the part of the inner room surface 2 and the points of reference 3 into the plurality of points of measuring 31. The method according to the invention further comprises sending the plurality of points of measuring 31 as data from the 3D scanning to the CAD/CAM system 40 and creating the digital 3D representation 32, 33, 34, 35 of the inner room surface 2 based on the data of the received points of measuring 31 from the 3D scanning 30 by means of the CAD/CAM system 40 and transforming the digital 3D representation 32 into the suitable number of individual digital plates 34, 35 with unique identification and dimensions and the digital CAM controlling manufacturing workflow for physically manufacturing each individual plate 20 accordingly for pre-fabrication and sending the digital CAM controlling manufacturing workflow to the at least one CAD/CAM controlled machine 50 for manufacturing and marking the physical plates 20 individually accordingly, and laying out each individually pre-fabricated plate 20 in the room 1 according to the predefined digital 3D representation 32, 33, 34. Aspects of the inventive method perform corresponding steps as above for the inventive system 10.

### NOMENCLATURE

1 Room/Space/Site/Stair case and/or stairs for installation of plates 20
2 At least a part of the inner room/space surface, such as part of a floor, wall and/or ceiling
3 Points of reference on the part of the inner room/space
4 Drain/Drainage/Sewer/Outlets and/or Water pipes/inlets
5 Operator/User/Installer/Layer/Designer of system/scanner/pre-fabricated plates
6 Door/Entrance to the room 2. 7 Washbasin. 8 Toilet. 9 Shower/Shower bath or bathtub.
10 System/Method
11 Sub-process of system/method with scan 30/digitalization of inner room part 2/plates 20
12 Sub-process of system/method showing pre-fabrication of plates 20
13 Sub-process of system/method showing packing plates 20 into packages 60, loading packages onto a transport 61, transport 70, unloading of packages 62, moving packages 63 to layout site and unpacking packages 64 at layout site
14 Sub-process of system/method showing packing plates 20 into packages 60/sets 25 of packages 21 before loading them onto a transport 70
15 Sub-process of system/method showing unloaded packages, moving packages 63 to site and unpacking packages 64 at layout site
20 Plates, e.g. clinker, boards for floors, walls and/or ceilings of gypsum, wood, stone, gypsum, fibreboards or the like suitable for covering floors, walls and ceilings in buildings
21 Package of plates. 22 Underside of a plate. 23 Upper/Top side of a plate.
24 Opening/Hole of a plate forming lead-through for drain/drainage/water pipes or the like
25 Two or more packages 21 of plates 20. 26 First end/side of plate. 27 Second end/side of plate. 28 Third end/side of plate. 29 Fourth end/side of plate.
30 3D scanner that could be portable and/or even handheld
31 Points of measuring
32 Digital 3D representation of the inner room surface 2 working as both a digital and physical map for the forming of the individual plates and their installation on/in the physical space/site
33 Digital grid pattern created by dividing the digital 3D representation into a suitable number of pieces
34 Digital pieces of the grid 33 representing the physical plates 20 for manufacture
35 Digital representations of the physical plates 20 in 3D for CAM manufacture
40 CAD and CAM system making digital plate representations and enabling the plates to be made physically
50 CNC machine (subtractive machining) and/or 3D printer (additive manufacture) and/or moulding and/or laminating each plate physically
60 Packing of plates into one or more packages
61 Loading plate packages 21 for transport
62 Unloading plate packages 21 from the transport
63 Moving/Transporting plate package/-s 21 to plate installation site 1
64 Unpacking packages 21 for installation of individual plates 20
70 Transport

## Claims

1. System (10) for coverage of at least a part of an inner surface (2) of a wet room (1) by means of a plurality of pre-fabricated and laid out plates (20), the system (10) comprising laid out points of reference (3) on the inner wet room surface (2),
a 3D scanner (30) adapted to scan the part of the inner wet room surface (2) and the points of reference (3) into a plurality of points of measuring (31) to enable creating a digital 3D representation (32, 33, 34, 35) of the part of the inner wet room surface (2),
a CAD/CAM system (40) configured to receive the points of measuring (31) from the 3D scanner (30) and to create the digital 3D representation (32, 33, 34, 35) of the part of the inner wet room surface (2) based on the points of measuring and to transform the digital 3D representation into a suitable number of individual digital plates (34) with identification and dimensions and a CAM controlling manufacturing workflow to manufacture each individual plate (20) accordingly,
at least one CAD/CAM controlled machine (50) configured to receive the CAM controlling manufacturing workflow and to physically manufacture the plates (20) individually accordingly, and
a layout of each individually pre-fabricated plate (20) in the wet room (1) according to the predefined digital 3D representation (32, 33, 34, 35),
**characterized in that** the CAM controlling manufacturing workflow is adapted to control the at least one CAD/CAM controlled machine (50) when manufacturing each plate (20) individually at least on its underside (22) and its upper side (23) to pre-form the plate to fit the upper surface of the inner room surface (2) of the wet room (1) onto which it is to be laid with its underside and to pre-form the plate to fit its upper side into any predefined slope of the final inner wet room surface when finished to enable drainage (4) or outflow of water or the like.

2. System (10) according to claim 1, wherein the at least one CAD/CAM controlled machine (50) is configured to physically manufacture and mark the plates (20) individually accordingly, and the transformation of the digital 3D representation (32) of the inner room surface (2) by means of the CAD/CAM system (40) comprises dividing the digital 3D representation of the inner room surface into a digital grid pattern (33) with a suitable number of individual digital pieces (34, 35) corresponding to the individual plates (20) making up the inner room surface and identifying and dimensioning each individual plate digitally to enable pre-fabricating each individual plate physically by means of the CAM controlling manufacturing workflow before laying-out the individual plates after manufacture according to the predefined grid pattern in the wet room (1).

3. System (10) according to claim 1 or 2, wherein the CAM controlling manufacturing workflow is adapted to control the at least one CAD/CAM controlled machine (50) when manufacturing each plate (20) individually to accomplish any predefined slopes of the finished inner room surface (2) and making any opening (4, 24) through one or more associated plates as lead-through for any drain and/or water inlet or gully drain in the wet room (1) if required according to the digital 3D representation of the inner room surface.

4. System (10) according to any preceding claim, comprising at least one packing (60) adapted to pack the pre-fabricated plates (20) in a pre-defined order according to the individual marking of each plate into at least one package (21, 25) of plates before the lay-out of each individual plate of the package (21) in the wet room (1) according to the predefined digital 3D representation (32, 33, 34).

5. System (10) according to claim 4, comprising at least a transport (70) to deliver the at least one plate package (21) at the room (1) before the lay-out of each individual plate (20) in the room according to the predefined digital 3D representation (32, 33, 34).

6. Method of pre-fabricating and laying out plates (20) for coverage of at least a part of an inner surface (2) of a wet room (1), comprising laying out points of reference (3) on the inner room surface (2),
3D scanning (30) of the part of the inner room surface (2) and the points of reference (3) into a plurality of points of measuring (31),
sending the plurality of points of measuring (31) from the 3D scanning to a CAD/CAM system (40),
creating a digital 3D representation (32, 33, 34, 35) of the inner room surface (2) based on the received points of measuring (31) from the 3D scanning (30) by means of the CAD/CAM system (40),
transforming the digital 3D representation (32) into a suitable number of individual digital plates (34, 35) with identification and dimensions and a digital CAM controlling manufacturing workflow for physically manufacturing each individual plate (20) accordingly for pre-fabrication,
sending the digital CAM controlling manufacturing workflow to at least one CAD/CAM controlled machine (50) for manufacturing the physical plates (20) individually accordingly, and
laying out each individually pre-fabricated plate (20) in the room (1) according to the predefined digital 3D representation (32, 33, 34),
**characterized by**
the CAM controlling manufacturing workflow comprising manufacturing each plate (20) individually at least on its underside (22) and its upper side (23) to preform the plate to fit the upper surface of the inner room surface (2) onto which it is to be laid with its underside and to fit its upper side into any predefined slope of the final inner room surface when finished to enable drainage (4, 24) or outflow of water.

7. Method according to claim 6, wherein the CAM controlling manufacturing workflow forms each plate (20) individually to accomplish any predefined slopes of the finished inner room surface (2) and makes any opening (24) through one or more associated plates to preform lead-through for any drain and/or water inlet (4) or gully drain in the wet room (1) if required according to the digital 3D representation of the inner room surface when covering the inner room surface.

8. Method according to any of claims 6 to 7, comprising packing (60) of the pre-fabricated plates (20) in a pre-defined order according to the individual marking of each plate into at least one package (21) of plates before laying out each individual plate in the wet room (1) according to the predefined digital 3D representation (32, 33, 34).

9. Method according to claim 8, comprising transport (70) for delivery of at least one plate package (21) at the room (1) before the lay-out of each individual plate (20) in the wet room (1) according to the predefined digital 3D representation (32, 33, 34).

10. Method according to claim 9, wherein the at least one CAD/CAM controlled machine (50) for manufacturing marks the physical plates (20) individually accordingly, and transforming the digital 3D representation (32) of the inner room surface (2) comprises dividing the digital 3D representation into a digital grid pattern (33) with a suitable number of individual digital pieces (34, 35) corresponding to the physical individual plates (20) making up the inner room surface and identifying and dimensioning each individual piece (34) digitally to enable pre-fabricating each individual plate (20) physically by means of the CAM controlling manufacturing workflow before laying out the individual plates physically after manufacture according to the predefined grid pattern (33) in the wet room (1).

## Patentansprüche

1. System (10) zur Abdeckung mindestens eines Teils einer Innenfläche (2) eines Nassraums (1) mittels einer Vielzahl von vorgefertigten und verlegten Platten (20), das System (10) umfassend verlegte Referenzpunkte (3) auf der Innennassraumfläche (2),
einen 3D-Scanner (30), der dazu ausgelegt ist, den Teil der Innennassraumfläche (2) und die Referenzpunkte (3) in eine Vielzahl von Messpunkten (31) zu scannen, um das Erzeugen einer digitalen 3D-Darstellung (32, 33, 34, 35) des Teils der Innennassraumfläche (2) zu ermöglichen,
ein CAD/CAM-System (40), das dazu ausgelegt ist, die Messpunkte (31) von dem 3D-Scanner (30) zu empfangen und die digitale 3D-Darstellung (32, 33, 34, 35) des Teils der Innennassraumfläche (2) basierend auf den Messpunkten zu erzeugen und die digitale 3D-Darstellung in eine geeignete Anzahl einzelner digitaler Platen (34) mit Identifizierung und Abmessungen und einem Cam-Steuerungs-Herstellungsarbeitsablauf umzuwandeln, um jede einzelne Platte (20) entsprechend herzustellen,
mindestens eine CAD/CAM-gesteuerte Maschine (50), die dazu ausgelegt ist, den CAM-Steuerungs-Herstellungsarbeitsablauf zu empfangen und die Platten (20) entsprechend einzeln physisch herzustellen, und
ein Verlegen jeder einzeln vorgefertigten Platte (20) im Nassraum (1) gemäß der vorgegebenen digitalen 3D-Darstellung (32, 33, 34, 35),
**dadurch gekennzeichnet, dass** der CAM-Steuerungs-Herstellungsarbeitsablauf abgestimmt ist, um die mindestens eine CAD/CAM-gesteuerte Maschine (50) zu steuern, wenn jede Platte (20) einzeln mindestens auf ihrer Unterseite (22) und ihrer Oberseite (23) hergestellt wird, um die Platte vorzuformen, um auf die Oberfläche der Innenraumfläche (2) des Nassraums (1) zu passen, auf die sie mit ihrer Unterseite zu legen ist, und um die Platte vorzuformen, um auf ihre Oberseite in jegliche vorgegebene Neigung der endgültigen Innennassraumfläche zu passen, wenn sie fertiggestellt ist, um ein Ablassen (4) oder Ausströmen von Wasser oder dergleichen zu ermöglichen.

2. System (10) nach Anspruch 1, wobei die mindestens eine CAD/CAM-gesteuerte Maschine (50) dazu ausgelegt ist, die Platten (20) entsprechend physisch herzustellen und einzeln zu markieren, und das Umwandeln der digitalen 3D-Darstellung (32) der Innenraumfläche (2) mittels des CAD/CAM-Systems (40) das Unterteilen der digitalen 3D-Darstellung der Innenraumfläche in ein digitales Rastermuster (33) mit einer geeigneten Anzahl von einzelnen digitalen Stücken (34, 35), die den einzelnen Platten (20) entsprechen, die die Innenraumfläche bilden, und das Identifizieren sowie Abmessen jeder einzelnen Platte digital umfasst, um ein physisches Vorfertigen jeder einzelnen Platte mittels des CAM-Steuerungs-Herstellungsarbeitsablaufs vor dem Verlegen der einzelnen Platten nach der Herstellung gemäß dem vorgegebenen Rastermuster in dem Nassraum (1) zu ermöglichen.

3. System (10) nach Anspruch 1 oder 2, wobei der CAM-Steuerungs-Arbeitsablauf abgestimmt ist, um die mindestens eine CAD/CAM-gesteuerte Maschine (50) zu steuern, wenn jede Platte ( 20 ) einzeln hergestellt wird, um jegliche vorgegebenen Neigungen der fertiggestellten Innenraumfläche (2) zu erzielen, und um jegliche Öffnung (4, 24) durch eine oder mehrere zugehörige Platten als Durchführung für jeglichen Abfluss und/oder Wassereinlass oder Abwasserabfluss in dem Nassraum (1) zu erstellen, falls erforderlich gemäß der digitalen 3D-Darstellung der Innenraumfläche.

4. System (10) nach einem der vorhergehenden Ansprüche, umfassend mindestens eine Packung (60), die ausgestaltet ist, um die vorgefertigten Platten (20) in einer vorgegebenen Reihenfolge gemäß der einzelnen Markierung jeder Platte in mindestens ein Paket (21, 25) von Platten vor dem Verlegen jeder einzelnen Platte des Pakets (21) in dem Nassraum (1) gemäß der vorgegebenen digitalen 3D-Darstellung (32, 33, 34) zu verpacken.

5. System (10) nach Anspruch 4, umfassend mindestens einen Transport (70) zum Abgeben des mindestens einen Plattenpakets (21) am Raum (1) vor dem Verlegen jeder einzelnen Platte (20) im Raum gemäß der vorgegebenen digitalen 3D-Darstellung (32, 33, 34).

6. Verfahren zum Vorfertigen und Verlegen von Platten (20) zur Abdeckung zumindest eines Teils einer Innenfläche (2) eines Nassraums (1), umfassend das Verlegen von Referenzpunkten (3) auf der Innenraumfläche (2),
3D-Scannen (30) des Teils der Innenraumfläche (2) und der Referenzpunkte (3) in eine Vielzahl von Messpunkten (31),
Senden der Vielzahl von Messpunkten (31) von dem 3D-Scannen an ein CAD/CAM-System (40),
Erzeugen einer digitalen 3D-Darstellung (32, 33, 34, 35) der Innenraumfläche (2) basierend auf den empfangenen Messpunkten (31) von dem 3D-Scannen (30) mittels des CAD/CAM-Systems (40),
Umwandeln der digitalen 3D-Darstellung (32) in eine geeignete Anzahl einzelner digitaler Platten (34, 35) mit Identifizierung und Abmessungen und einem digitalen CAM-Steuerungs-Herstellungsarbeitsablauf, um jede einzelne Platte (20) entsprechend für die Vorfertigung physisch herzustellen,
Senden des digitalen Cam-Steuerungs- Herstellungsarbeitsablaufs an mindestens eine CAD/CAM-gesteuerte Maschine (50), um die physischen Platten (20) entsprechend einzeln herzustellen, und
Verlegen jeder einzeln vorgefertigten Platte (20) im Raum (1) gemäß der vorgegebenen digitalen 3D-Darstellung (32, 33, 34),
**gekennzeichnet durch**
den CAM-Steuerungs-Herstellungsarbeitsablauf umfassend, dass jede Platte (20) einzeln mindestens auf ihrer Unterseite (22) und ihrer Oberseite (23) hergestellt wird, um die Platte vorzuformen, um auf die Oberfläche der Innenraumfläche (2) zu passen, auf die sie mit ihrer Unterseite zu legen ist, und um auf ihre Oberseite in jegliche vorgegebene Neigung der endgültigen Innenraumfläche zu passen, wenn sie fertiggestellt ist, um ein Ablassen (4, 24) oder Ausströmen von Wasser zu ermöglichen.

7. Verfahren nach Anspruch 6, wobei der CAM-Steuerungs-Herstellungsarbeitsablauf jede Platte (20) einzeln bildet, um jegliche vorgegebenen Neigungen der fertiggestellten Innenraumfläche (2) zu erzielen, und jegliche Öffnung (24) durch eine oder mehrere zugehörige Platten erstellt, um die Durchführung für jeglichen Abfluss und/oder Wassereinlass (4) oder Abwasserabfluss in dem Nassraum (1) vorzuformen, falls erforderlich gemäß der digitalen 3D-Darstellung der Innenraumfläche, wenn die Innenraumfläche abgedeckt wird.

8. Verfahren nach einem der Ansprüche 6 bis 7, umfassend die Packung (60) der vorgefertigten Platten (20) in einer vorgegebenen Reihenfolge gemäß der einzelnen Markierung jeder Platte in mindestens ein Paket (21) von Platten vor dem Verlegen jeder einzelnen Platte in dem Nassraum (1) gemäß der vorgegebenen digitalen 3D-Darstellung (32, 33, 34).

9. Verfahren nach Anspruch 8, umfassend einen Transport (70) zum Abgeben mindestens eines Plattenpakets (21) am Raum (1) vor dem Verlegen jeder einzelnen Platte (20) in dem Nassraum (1) gemäß der vorgegebenen digitalen 3D-Darstellung (32, 33, 34).

10. Verfahren nach Anspruch 9, wobei die mindestens eine CAD/CAM-gesteuerte Maschine (50) zum Herstellen die physischen Platten (20) einzeln entsprechend markiert und das Umwandeln der digitalen 3D-Darstellung (32) der Innenraumfläche (2) das Unterteilen der digitalen 3D-Darstellung in ein digitales Rastermuster (33) mit einer geeigneten Anzahl von einzelnen digitalen Stücken (34, 35), die den physischen einzelnen Platten (20) entsprechen, die die Innenraumfläche bilden, und das Identifizieren sowie Abmessen jedes einzelnen Stücks (34) digital umfasst, um ein physisches Vorfertigen jeder einzelnen Platte (20) mittels des CAM-Steuerungs-Herstellungsarbeitsablaufs vor dem physischen Verlegen der einzelnen Platten nach der Herstellung gemäß dem vorgegebenen Rastermuster (33) in dem Nassraum (1) zu ermöglichen.

## Revendications

1. Système (10) de couverture d'au moins une partie d'une surface intérieure (2) d'une pièce humide (1) au moyen d'une pluralité de plaques préfabriquées et disposées (20), le système (10) comprenant des points de référence (3) disposés sur la surface intérieure de pièce humide (2),
un scanner 3D (30) adapté pour balayer la partie de la surface intérieure de pièce humide (2) et les points de référence (3) en une pluralité de points de mesure (31) pour permettre la création d'une représentation 3D numérique (32, 33, 34, 35) de la partie de la surface intérieure de pièce humide (2),
un système CAO/FAO (40) configuré pour recevoir les points de mesure (31) provenant du scanner 3D (30) et pour créer la représentation 3D numérique (32, 33, 34, 35) de la partie de la surface intérieure de pièce humide (2) sur la base des points de mesure et pour transformer la représentation 3D numérique en un nombre approprié de plaques numériques individuelles (34) avec une identification et des dimensions et un flux de travail de fabrication commandé par FAO pour fabriquer chaque plaque individuelle (20) en conséquence,
au moins une machine commandée CAO/FAO (50) configurée pour recevoir le flux de travail de fabrication commandé par FAO et pour fabriquer physiquement les plaques (20) individuellement en conséquence, et
une disposition de chaque plaque préfabriquée individuellement (20) dans la pièce humide (1) selon la représentation 3D numérique prédéfinie (32, 33, 34, 35),
**caractérisé en ce que** le flux de travail de fabrication commandé par FAO est adapté pour commander l'au moins une machine commandée par CAO/FAO (50) lors de la fabrication de chaque plaque (20) individuellement au moins sur sa face inférieure (22) et son côté supérieur (23) pour préformer la plaque pour s'adapter à la surface supérieure de la surface intérieure de pièce (2) de la pièce humide (1) sur laquelle elle doit être disposée avec sa face inférieure et pour préformer la plaque pour s'adapter son côté supérieur à n'importe quelle pente prédéfinie de la surface intérieure de pièce humide finale lorsqu'elle est terminée pour permettre un drainage (4) ou un écoulement de sortie d'eau ou similaire.

2. Système (10) selon la revendication 1, dans lequel l'au moins une machine commandée par CAO/FAO (50) est configurée pour fabriquer et marquer physiquement les plaques (20) individuellement en conséquence, et la transformation de la représentation 3D numérique (32) de la surface intérieure de pièce (2) au moyen du système CAO/FAO (40) comprend la division de la représentation 3D numérique de la surface intérieure de pièce en un motif de grille numérique (33) avec un nombre approprié de pièces numériques individuelles (34, 35) correspondant aux plaques individuelles (20) constituant la surface intérieure de pièce et l'identification et le dimensionnement numérique de chaque plaque individuelle pour permettre la préfabrication physique de chaque plaque individuelle au moyen du flux de travail de fabrication commandé par FAO avant la disposition des plaques individuelles après fabrication selon le motif de grille prédéfini dans la pièce humide (1).

3. Système (10) selon la revendication 1 ou 2, dans lequel le flux de travail de fabrication commandé par FAO est conçu pour commander l'au moins une machine commandée par CAO/FAO (50) lors de la fabrication individuelle de chaque plaque (20) pour accomplir n'importe quelle pente prédéfinie de la surface intérieure de pièce finie (2) et réaliser n'importe quelle ouverture (4, 24) à travers une ou plusieurs plaques associées en tant que traversée pour n'importe quel drain et / ou entrée d'eau ou vidange de puisard dans la pièce humide (1) si nécessaire selon la représentation 3D numérique de la surface intérieure de pièce.

4. Système (10) selon l'une quelconque des revendications précédentes, comprenant au moins une garniture (60) conçue pour emballer les plaques préfabriquées (20) dans un ordre prédéfini en fonction du marquage individuel de chaque plaque dans au moins un paquet (21, 25) de plaques avant la disposition de chaque plaque individuelle du paquet (21) dans la pièce humide (1) selon la représentation 3D numérique prédéfinie (32, 33, 34).

5. Système (10) selon la revendication 4, comprenant au moins un transport (70) pour distribuer l'au moins un paquet de plaques (21) au niveau de la pièce (1) avant la disposition de chaque plaque individuelle (20) dans la pièce selon la représentation 3D numérique prédéfinie (32, 33, 34).

6. Procédé de préfabrication et de disposition de plaques (20) pour la couverture d'au moins une partie d'une surface intérieure (2) d'une pièce humide (1), comprenant la disposition de points de référence (3) sur la surface intérieure de pièce (2),
un balayage 3D (30) de la partie de la surface intérieure de pièce (2) et des points de référence (3) en une pluralité de points de mesure (31),
l'envoi de la pluralité de points de mesure (31) du balayage 3D à un système CAO/FAO (40),
la création d'une représentation 3D numérique (32, 33, 34, 35) de la surface intérieure de pièce (2) sur la base des points de mesure reçus (31) à partir du balayage 3D (30) au moyen du système CAO/FAO (40),
la transformation de la représentation 3D numérique (32) en un nombre approprié de plaques numériques individuelles (34, 35) avec identification et dimensions et un flux de travail de fabrication commandé par FAO numérique pour fabriquer physiquement chaque plaque individuelle (20) en conséquence pour une préfabrication,
l'envoi du flux de travail de fabrication commandé par FAO numérique à au moins une machine commandée par CAO/FAO (50) pour fabriquer les plaques physiques (20) individuellement en conséquence, et
la disposition de chaque plaque préfabriquée individuellement (20) dans la pièce (1) selon la représentation 3D numérique prédéfinie (32, 33, 34),
**caractérisé en ce que**
le flux de travail de fabrication commandé par FAO comprend la fabrication individuelle de chaque plaque (20) au moins sur sa face inférieure (22) et son côté supérieur (23) pour préformer la plaque pour s'adapter à la surface supérieure de la surface intérieure de pièce (2) sur laquelle elle doit être disposée avec sa face inférieure et pour s'adapter son côté supérieur à n'importe quelle pente prédéfinie de la surface intérieure de pièce humide finale lorsqu'elle est terminée pour permettre un drainage (4, 24) ou un écoulement de sortie d'eau.

7. Procédé selon la revendication 6, dans lequel le flux de travail de fabrication commandé par FAO forme chaque plaque (20) individuellement pour accomplir n'importe quelle pente prédéfinie de la surface intérieure de pièce finie (2) et réaliser n'importe quelle ouverture (24) à travers une ou plusieurs plaques associées pour préformer une traversée pour n'importe quel drain et / ou entrée d'eau (4) ou vidange de puisard dans la pièce humide (1) si nécessaire selon la représentation numérique en 3D de la surface intérieure de pièce lors du recouvrement de la surface intérieure de la pièce.

8. Procédé selon l'une quelconque des revendications 6 à 7, comprenant une garniture (60) des plaques préfabriquées (20) dans un ordre prédéfini en fonction du marquage individuel de chaque plaque dans au moins un paquet (21) de plaques avant la disposition de chaque plaque individuelle dans la pièce humide (1) selon la représentation 3D numérique prédéfinie (32, 33, 34).

9. Procédé selon la revendication 8, comprenant le transport (70) pour distribuer au moins un paquet de plaques (21) au niveau de la pièce (1) avant la disposition de chaque plaque individuelle (20) dans la pièce humide (1) selon la représentation 3D numérique prédéfinie (32, 33, 34).

10. Procédé selon la revendication 9, dans lequel l'au moins une machine commandée par CAO/FAO (50) destinée à fabriquer marque les plaques physiques (20) individuellement en conséquence, et la transformation de la représentation 3D numérique (32) de la surface intérieure de pièce (2) comprend la division de la représentation 3D numérique en un motif de grille numérique (33) avec un nombre approprié de pièces numériques individuelles (34, 35) correspondant aux plaques individuelles physiques (20) constituant la surface intérieure de pièce et l'identification et le dimensionnement numérique de chaque plaque individuelle (34) pour permettre la préfabrication physique de chaque plaque individuelle (20) au moyen du flux de travail de fabrication commandé par FAO avant la disposition physique des plaques individuelles après fabrication selon le motif de grille prédéfini (33) dans la pièce humide (1).
